(19)

Europäisches
Patentamt

European
Patent Office

Office européen
des brevets

(11) **EP 3 107 207 A1**

(12) **EUROPEAN PATENT APPLICATION**

(43) Date of publication:
**21.12.2016 Bulletin 2016/51**

(51) Int Cl.:
*H03B 5/12* *(2006.01)*    *H03K 17/95* *(2006.01)*

(21) Application number: **16168773.6**

(22) Date of filing: **09.05.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **20.05.2015 EP 15461535**

(71) Applicant: **Aiut Sp. z o.o.**
**44-109 Gliwice (PL)**

(72) Inventor: **Zajdel, Jozef Henryk**
**40-139 Katowice (PL)**

(74) Representative: **Sielewiesiuk, Jakub**
**AOMB Polska Sp. z o.o.**
**Emilii Plater 53, 28th floor**
**00-113 Warszawa (PL)**

(54) **A PROXIMITY SENSOR FOR DETECTING A CONDUCTIVE TARGET OBJECT AND A CONSUMPTION METER COMPRISING SUCH SENSOR**

(57)    The invention relates to a proximity sensor for detecting a conductive target object, comprising: an oscillator circuit with an inductance L1, preferably a coil, configured to create an external magnetic field, and a detector circuit, wherein the external electromagnetic field of the inductance L1 is suitable for and configured to create eddy currents in the conductive target object, and wherein the detector circuit is suitable and configured for examining the amplitude of oscillations of the oscillator circuit (2) and optionally is also suitable for and configured to respectively change the state of an output signal due to changes of the amplitude of oscillations, characterized in that the oscillator circuit is an electric circuit of a generator of oscillations, comprising the inductance L1, a field transistor T1, preferably an enhancement-mode field transistor, and a resistance R1 connected to the source or the drain of the transistor T1, wherein the inductance L1 is connected directly between the gate and the drain of the transistor T1.

The invention relates also to a consumption meter comprising a rotating element, rotation of which corresponds to a measured flow, characterized in that the consumption meter further comprises a conductive target element fixed to said rotating element of the meter), and the proximity sensor according to the invention, said proximity sensor being suitable for and configured to detect the target element, wherein optionally the target element is made of nonferrous metal.

Fig. 8

EP 3 107 207 A1

**Description**

Technical field

The invention relates to a proximity sensor for detecting a conductive target object using eddy currents.
The invention also relates to a consumption meter, for example gas meter or water meter, comprising such sensor.

Background

There are three known possibilities of detection the distance to a target element using eddy currents.
The most popular possibility is based on a generator using a negative resistance allowing to examine the current used by the generator. The eddy current of the target element causes a rise in the generator current. The value of the generator current gives information on a quantity and a distance to the target element and is accessed continuously after each period of an oscillation. The example of such a solution is a chipset TCA505 produced by Infineon.
The second possibility is based on a LC passive resonant tank which is excited and its damped oscillations are observed. The damping rate depends on the eddy current of the target element and can be obtained by measuring time when an amplitude of oscillation gets to a certain level. This solution is utilized in the Texas Instruments patented flow meter (http://www.ti.com/lit/an/slaa138a/slaa138a.pdf).
The third possibility measures small changes in a generator frequency when the target element with eddy current is close to a main resonant tank. This solution is often required to be tuned each time before use and is usually good enough for non-industrial applications.
The present invention discloses a new a proximity sensor for detecting a conductive target object using eddy currents.

Summary

Oscillator circuit

The sensor is based on the simple oscillator (generator) circuit disclosed in the application EP15461535, which is able to work with supply voltages less than 3V. This oscillations generator ensures stability of the operating point, does not require special selection or adjustment of the operating point and at the same time it comprises the minimal number of elements.
According to said invention, an electric circuit of a generator of oscillations, comprising an enhancement-mode field transistor T1, inductance L1 and resistance R1 connected to the source or the drain of the transistor T1, is characterized in that the inductance L1 is connected directly between the gate and the drain of the transistor T1.
Alternatively, according to the invention, an electric circuit of a generator of oscillations, comprising an depletion-mode field transistor T1, inductance L1 and resistance R1 connected with its one end to the source of the transistor T1, is characterized in that the inductance L1 is connected directly between the gate of the transistor T1 and the other end of the resistance R1.
The aforementioned alternatives are in fact, from the point of view of a skilled person, i.e. an electronic engineer, two alternative embodiments of the same inventive idea, involving same or corresponding technical features for providing the same technical effect - which is spontaneous generation of oscillations in an electric circuit. In the most general aspect of the present invention, the inductance L1 is connected directly between the gate of the field transistor T1 and a point P of the inventive generator's circuit, wherein the point P is selected such that after the gate of the transistor is connected with the point P and connecting the transistor to the power supply, the Gate Threshold Voltage of the transistor T1 occurs in the point P. The transistor T1 may be an n-channel enhanced mode field transistor, a p-channel enhanced mode field transistor, an n-channel depletion mode field transistor or a p-channel depletion mode field transistor, while the construction details of the invention circuit depend on the type of the transistor T1 used.
Optionally, the circuit additionally comprises a first capacity C1, in particular exactly one first capacity C1, connected in parallel to the resistance R1.
Optionally, the circuit additionally comprises a second capacity C2, in particular exactly one second capacity C2, connected in parallel to the inductance L1.
Optionally, the circuit comprises exactly one transistor T1 and/or exactly one inductance L1 and/or exactly one resistance R1.
Embodiments of the generator circuit are presented in a more detailed way below.

**Proximity sensor**

The main elements of the proximity sensor according to the invention are: the oscillator circuit (as disclosed above) with an inductance (inductor), preferably a coil, and a detector circuit.

The oscillator circuit generates oscillations of substantially constant amplitude. If a conductive target object is present in the proximity of the inductor, the external electromagnetic field of inductor creates eddy currents in said target. These eddy currents in return affect the current in the inductor, which causes variation of the amplitude of the oscillations. Geometry of the inductor (coil) has a significant impact on the sensitivity of the sensor.

For a sufficiently large target objects and small distances to the inductor, the oscillation amplitude may decrease to zero. Practically, it is enough to detect an approach of a target which occurs when an amplitude is decreased to a required level. The detector circuit examines the amplitude of oscillations and respectively changes the state of an output signal. The output signal is switched ON (target is present) if an amplitude is less than a given low level. The output signal is switched OFF (target is absent) if an amplitude is higher than a given high level.

A non zero positive difference (hysteresis) between the defined high and low levels is required for a reliable work of the proximity sensor.

According to the invention, a proximity sensor for detecting a conductive target object, comprises:

an oscillator circuit with an inductance L1, preferably a coil, configured to create an external magnetic field, and a detector circuit,
wherein the external electromagnetic field of the inductance L1 is suitable for and configured to create eddy currents in the conductive target object,
and wherein the detector circuit is suitable and configured for examining the amplitude of oscillations of the oscillator circuit and optionally is also suitable for and configured to respectively change the state of an output signal due to changes
of the amplitude of oscillations,

and is characterized in that the oscillator circuit is an electric circuit of a generator of oscillations, comprising the inductance L1, a field transistor T1, preferably an enhancement-mode field transistor, and a resistance R1 connected to the source or the drain of the transistor T1, wherein the inductance L1 is connected directly between the gate and the drain of the transistor T1.

Optionally the detector circuit comprises a comparator suitable for and configured to detect a desired level of the amplitude of oscillations of the oscillator circuit, wherein a desired level of the amplitude of the oscillations is fed into the one input of comparator, while the signal from the inductance L1 is fed to the other input of comparator.

Optionally the detector circuit comprises a first 1-bit register, optionally suitable for and configured to be initially reset and set by means of a signal from the comparator if the signal corresponding to the amplitude of oscillations greater than desired level of the amplitude occurs in any moment in a period of time longer than the period of oscillations.

Optionally the detector circuit further comprises a second 1-bit register connected in such a way that the output of the comparator is suitable for setting the first 1-bit register in one state and a first auxiliary signal is suitable for setting the first register in an opposite state, and wherein a second auxiliary signal is suitable for copying the state of the first register to the second register.

Optionally an output signal (target is present) of the sensor is a state of the second register, which is set as an inverted state of the first register (6) before the reset of the first register.

Optionally the sensor is suitable for detecting the target being an RLC circuit, optionally RLC parallel circuit.

Optionally the resonant frequency of the RLC circuit is close to the frequency of the generator circuit.

All configurations of circuits, disclosed in the application EP15461535, may be used as an oscillator circuit in a proximity sensor according to the invention. In each case, a high and low levels should be chosen accordingly to the required detection conditions.

**Consumption meter**

The proximity sensors are suitable for applications in the consumption meters, such as for example gas meters or water meters.

There are known the flow meters with a mechanical drum-type counter comprising a magnet on at least one of the wheels (usually the least significant wheel), and a sensor (usually Hall effect sensor) suitable for detecting the magnet, which enables that a flow is thus calculated by counting the magnet passing the sensor, which further enables for use of automated meter reading (AMR) technology. However, the presence of the magnet causes that the meter readings can be manipulated, for example by placing a strong magnet in a proximity of the meter.

Therefore the object of the present invention is also to provide a meter which is less sensitive for manipulation by externally applied magnets.

The solution is to provide a meter in which a magnet fixed to the any kind of the rotating element for counting the pulses (especially a magnet fixed to the least significant digit of index drum) is replaced by a conductive target object, which can be detected by a proximity sensor placed in a distance which enables for detection. The meter comprising the conductive target object, optionally made of nonferrous metal, placed on one of the wheels of the meter (especially counter), and a proximity sensor suitable for detecting said target is less sensitive for manipulation by externally applied magnetic fields than the meters comprising a magnet.

A proximity sensor according to this invention is also suitable for this application.

Therefore the present invention relates also to a consumption meter comprising a rotating element, rotation of which corresponds to a measured flow, characterized in that the consumption meter further comprises a conductive target element fixed to said rotating element of the meter, and the proximity sensor according to any of the preceding claims, said proximity sensor being suitable for and configured to detect the target element, wherein optionally the target element is made of nonferrous metal.

Optionally the meter comprises a mechanical drum-type counter with wheels and with a conductive target element fixed to at least one of the wheels of the counter, optionally to the least significant wheel, and the proximity sensor according to any of the preceding claims from 1 to 10, said proximity sensor being suitable for and configured to detect the target element, wherein optionally the target element is made of nonferrous metal.

The target may be in the form of a thin metal plate, coil or LCR circuit.

Brief description of drawings

The embodiments of the present invention are presented in a more detailed way with reference to the attached drawings, in which:

Fig. 1, 2 i 3 - illustrate the oscillator circuits disclosed in the applicationEP15461535, that may be used as an oscillator circuit in a proximity sensor according to the invention,

Fig. 4 - shows the scheme of fig. 1 with a first and second capacities added; in a similar manner a first and/or second capacity may be added to circuits shown in fig.2 and fig. 3,

Fig. 5 - shows the final possible schemes of the oscillator circuits depending on the type of the transistor T1 used,

Fig. 6 - shows an example inventive circuit used for simulations made in the LTSPICE software,

Fig. 7 - shows the results of the LTSPICE software simulation (voltage as a function of time) made for the circuit shown in fig. 6, wherein in the vertical axis there is the value of the Out signal in volts and on the horizontal axis there is the time in microseconds,

Fig. 8 - shows the whole circuit scheme of the proximity sensor according to the invention and explains its operating principle,

Fig. 9 - shows the target in a form of a RLC circuit,

Fig. 10 - shows a practical implementation of the basic scheme from Fig.8,

Fig. 11-shows microprocessor implementation of the basic scheme from Fig.8,

Fig. 12 - shows a schematic view of a consumption meter comprising a conducive target and proximity sensor.

Detailed description and embodiments

**Oscillator circuit**

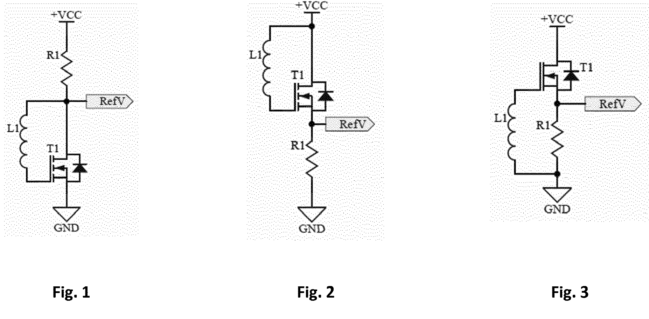

The electric circuit of a generator of oscillations, comprises a field transistor T1, inductance L1 and resistance R1. The inductance L1 is connected either between the gate and the drain as show in fig. 1 and fig. 2 for an enhancement-mode transistor or between the gate and the pole of a supply for a depletion-mode transistor, as show in fig. 3.

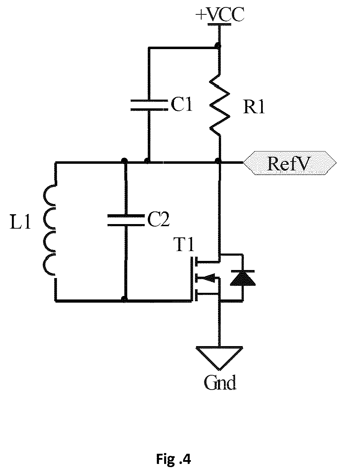

It is possible to add an additional parallel first capacity C1 to the resistance R1 and/or an additional parallel second capacity C2 to the inductance L1, as shown by way of example in fig. 4, but they are not necessary for generating oscillations. The second capacity C2 makes oscillations more sinusoidal but also makes oscillations more difficult to evoke - because when the second capacity C2 is present - starting of oscillation takes more time. Therefore the basic structures of the inventive circuit are those in figs. 1, 2 and 3.

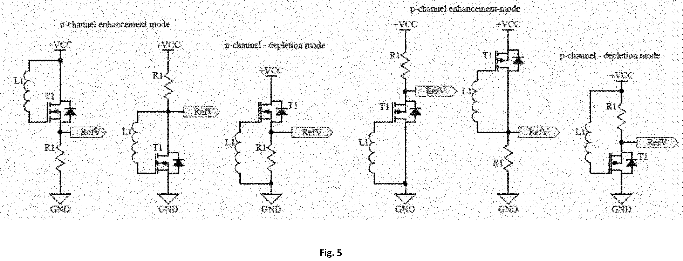

Depending on the type of the transistor used, the final possible schemes of inventive circuits are shown in fig. 5.

For generation of oscillations a circuit comprising exactly one transistor T1, exactly one inductance L1 and exactly one resistance R1 is sufficient.

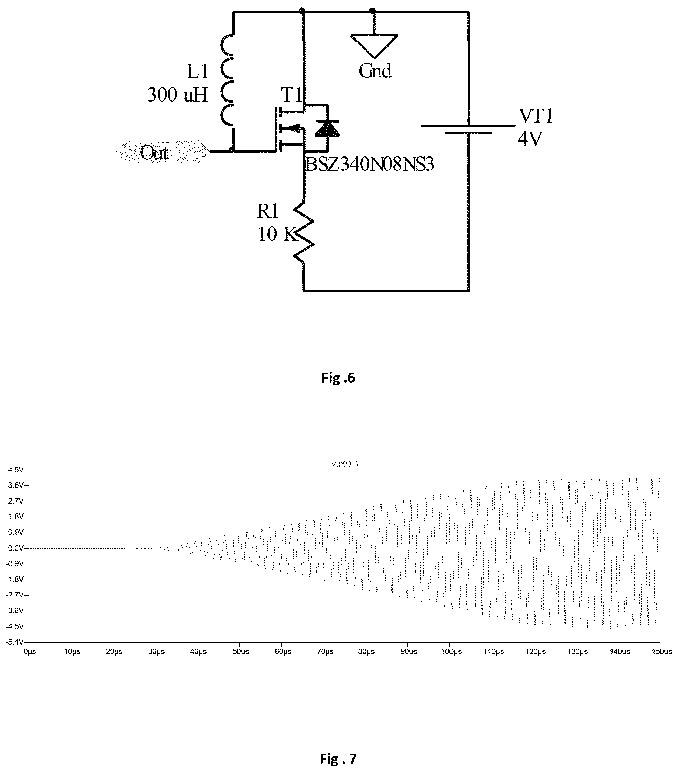

The generated signal can be fed/taken from the point marked as RefV in the figures or from the gate of the transistor T1. Fig. 6 shows an example inventive circuit used for simulations made in the LTSPICE software. The result of the simulation (voltage as a function of time) is shown in fig.7, in which in the vertical axis there is the value of the Out signal in volts and on the horizontal axis there is the time in microseconds.

**Proximity sensor**

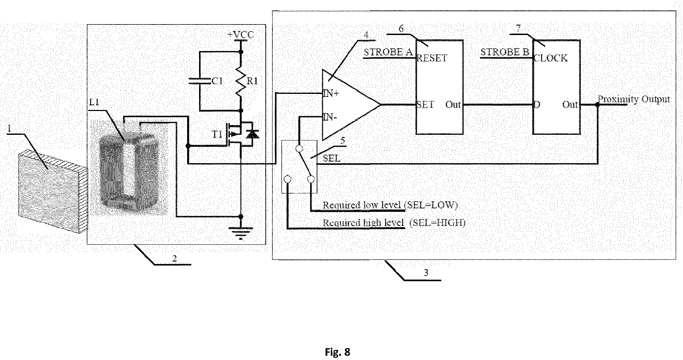

Fig. 8 shows the whole circuit scheme of a proximity sensor and explains its operating principle.

Target (marker) (1) is a thin electrically conductive plate, which is placed in an alternating electromagnetic field of the coil L1, which causes generation of eddy currents in the plate. In return, the eddy currents interact with the coil and cause a change in an oscillation amplitude of the generator circuit (3).

For certain parameters of the target and the coil, the amplitude of the generator is a function of location of the target relative to the coil.

The target is detected when the analog comparator (4) signals that the value of the amplitude corresponds to the desired location.

A detection circuit comprises the comparator (4), a first 1-bit digital register (6) for storing the result of comparison, and a second 1-bit digital register (7) for storing the output signal and controlling an analog switch (5) of analog signal connected to a negative input of comparator (4).

A common detector circuits with a rectifying diode and a capacity, works in such a way that in the first step the maximum amplitude is detected and then compared the it to the desired value. Using a capacity causes an unwanted delay.

In the present invention, the circuit (3) detects whether the amplitude exceeds the desired level at any time during one oscillation. This is obtained in such a way that the first one-bit digital register (6) is reset by means of a STROBE A and set by the comparator (4) when the oscillation amplitude is greater than desired level. Before the next reset, the state of the register (6) is stored in the second one-bit digital-register (7) with a STROBE B. In this way the state (Proximity Output) register (7) continuously indicates the presence of the marker.

The delay of the indication of the presence of the marker is not longer than the time of repetitions of the signal STROBE B. In this way the time is a little longer than the oscillation period of the generator.

A hysteresis is used to eliminate an unwanted change state of the register(7). Hysteresis is achieved using the switch (5) which changes the required levels of detection depending on the state of the register (7).

In one embodiment the target (1) is a coil or a RLC circuit. Replacing the target in a thin electrically conductive plate form with a resonance circuit allows to increase a distance at with the target is detected by the sensor.

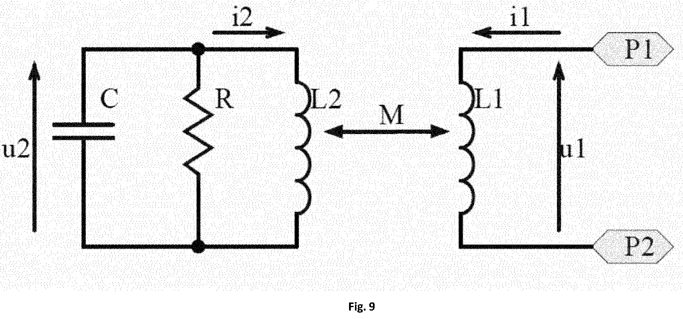

Fig. 9 presents electrical schematics utilizing the resonant circuit. Here the inductor L1 is an equivalent of the inductor L1 from Fig. 8. The remaining parts: inductor L2, capacitor C and resistance R, form the resonance circuit. The resistance R (usually omitted in similar designs) plays an important role, which is described below.

Other symbols in Fig. 9 represent:

u1- potential drop on inductor L1,
u2 - potential drop on inductor L2,
i1- electric current in inductor L1,
i2 - electric current in inductor L2,
M - mutual inductance between inductors L1 and L2,
P1, P2 - connector points of the inductor L1.

Applying the Laplace transform with complex parameter p to equations describing schematics in Fig. 9 one gets:

$$(1) \quad u1 = p \cdot L1 \cdot i1 + p \cdot M \cdot i2$$

$$(2) \quad u2 = p \cdot L2 \cdot i2 + p \cdot M \cdot i1$$

$$(3) \quad M = \lambda \cdot \sqrt{L1 \cdot L2}, \text{ where } -1 \le \lambda \le 1,$$

$$(4) \quad i2 = -\left(\frac{1}{R} + p \cdot C\right) \cdot u2 = -\frac{1 + p \cdot R \cdot C}{R} \cdot u2$$

Solving the above set of equations against the impedance seen between points P1, P2 one gets:

$$(5) \qquad Z_1 = \frac{u1}{i1} = p \cdot L1 \cdot \left( \frac{1 + (1-\lambda^2) \cdot p \cdot \frac{L2}{R} + (1-\lambda^2) \cdot p^2 \cdot L2 \cdot C}{1 + p \cdot \frac{L2}{R} + p^2 \cdot L2 \cdot C} \right)$$

In case of no mutual inductive coupling ($\lambda = 0$) the impedance Z1 equals to

$$(6) \qquad Z_1 = \frac{u1}{i1} = p \cdot$$

L1 that is the inductor L1 alone.

In case of maximal positive coupling ($\lambda = 1$) the system behaves as a resonator:

$$(7) \qquad \frac{u1}{i1} = p \cdot L1 \cdot \left( \frac{1}{1 + p \cdot \frac{L2}{R} + p^2 \cdot L2 \cdot C} \right)$$

which Q-factor depends on resistor R. In case when R is missing (equivalent to infinite value of the resistance) there is no dumping of oscillations and the circuit has a narrow resonance bandwidth.

Using a finite value of the resistance R allows to choose a wider resonance bandwidth.

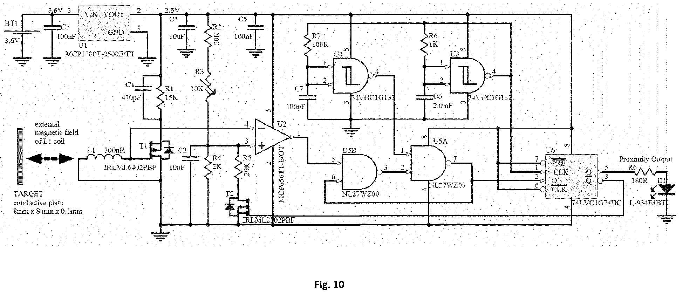

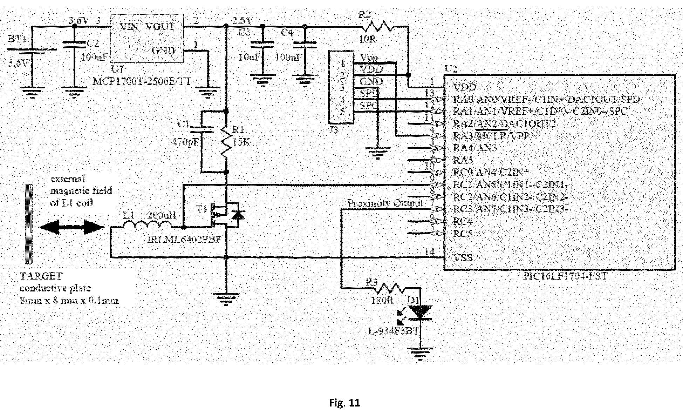

zA practical implementation of the basic scheme from Fig.8 is shown in Fig.10 and Fig. 11. The numbers in Fig.10 and Fig. 11, next to the inputs and outputs of the devices, are pin numbers.

A transistor T1, a coil L1, a resistor R1 and a capacitance C1, form a generator circuit, of which amplitude of oscillation depends on the position of the target (marker) (1) in a form of an electrically conductive plate (corresponding to 1 in Fig.8).

The amplitude of oscillation at the gate of the transistor T1 is compared in the circuit U2 to the level set by the voltage divider R2, R3, R4 and R5 .
U2 is an analog comparator whose inputs (positive and negative) are chosen in a way that the comparator output is a logical zero if the signal from the generator is greater than the level obtained from the divider.

Exchange inputs (negative and positive) of the comparator with respect to Fig. 8 by the logic levels of the signals enrolling flip-flop ( corresponding to register (6) in Fig. 8) formed by the U5A element and the U5B element.

Circuits U3 and U4 are Schmitt triggers and are used to produce signals (STROBE A and STROBE B in Fig. 8) which control flip-flops (corresponding to registers (6) and (7) in Fig. 8).

The STROBE B signal generator is implemented on the chip U3. The STROBE A signal, which is the delayed and inverted with respect to the STROB B signal, is realized on the chip U4.

The transistor T2 and the resistor R5 are used to switch the required level (corresponding to switch (5) in Fig. 8). D1 LED diode lights up when the marker is found in the field of the coil L1.

A variable resistor R3 is used to set the operating point (detection level) of the comparator U2, depending on the oscillations amplitude of the generator.

In order to set the working point one should move the target away from the coil L1 and set the minimum value of R3, at which the D1 LED is still steady lit, indicating the presence of the target. Then one should slowly increase the value of R3 until the LED goes out, indicating lack of target in the coil field. Moving the target to a sufficiently close distance to the coil should result in lighting of the D1 LED diode.

A microcontroller based implementation of schematics from Fig. 8 is presented in Fig. 11. A datasheet for the microcontroller is available at manufacturers website:

http://ww1.microchip.com/downloads/en/DeviceDoc/40001715B.pdf
(access April 21st 2016)

The microcontroller implementation from Fig. 11 is equivalent to the solution from Fig. 10 that uses discrete electronic devices.

In Fig. 11, microcontroller subsystem U2 is an 8-bit digital-to-analog converter (DAC), which is used to generate a reference voltage (Vref). This DAC in Fig. 11 is equivalent in functionality to the resistors R2, R3, R4, R5 and the transistor T2 in Fig. 10.

A change in the reference voltage depending on the expected state (marker present or no marker) is accomplished by providing a proper numeric value to the input of the 8-bit DAC. A role of a 1-bit register, marked as 6 in Fig. 8, is played in the solution presented in Fig. 11 by one bit bit-field C1IF (Comparator 1 Interrupt Flag) of microcontroller register PIR2. The interrupt register PIR2 is used without enabling generation of interrupts. An equivalent function is achieved in Fig. 10 by elements U5A and U5B.

A role of a 1-bit register, marked as 6 in Fig. 8, is played in the solution presented n Fig. 11 by one bit bit-field RC3 of microcontroller register RC. An equivalent function is achieved in Fig. 10 by the element U6.

The microcontroller used in schematics in Fig. 11, by default connects the output of the 8-bit DAC to the positive input of a used comparator. The signal from generator is therefore connected to negative (inverting) input of the comparator by pin RC1.

Connector J3 in Fig. 11 is used to program the microcontroller

Controlling signals STROBE A and STROBE B (Fig. 8) are implemented in Fig. 11 by a software, which relevant fragment written in C programming language is presented below:

```
/*****************************************************/
/* program for Fig.11 in C language            */
/* Diode LED D1 is ON if MARKER  is present */
/*****************************************************/

#define Proximity_output   LATCbits.LATC3
#define REAL_LEVEL  50                      // actual amplitude of the generator
#define NO_MARK_LEVEL  REAL_LEVEL-2    // required level for no MARKER
#define IS_MARK_LEVEL  NO_MARK_REAL_LEVEL-2   //

void main()
{
  unsigned char i;        //auxiliary

  OSCCONbits.IRCF = 0b1101;    // CPU clock = 4MHz


    //configure pins
  ANSELC = 0x02;         //  only RC1 analog - comparator in
  TRISC = 0x02;          //  only RC1 is input, other pins output

    //configure devices
    //enable fixed voltage reference 1.024V used by DAC
  FVRCON = 0b10000100;

    //enable DAC converter, FVR Buffer2 as positive source, GND as negative
  DAC1CON0 = 0b10001000; // unit = 4 mV

    //enable first comparator, non inverted polarity, normal power
  CM1CON0 = 0b10000100;

    // configure comparator inputs and interrupts
  CM1CON1 = 0b01101001;  // interrupt on negative edge
    // DAC in positive input, AN1 pin in negative input

  Proximity_output = 0;    // startup default is no MARKER

  while (1)                // main loop
  {
    // set reference as  MARKER present
    DAC1CON1 = IS_MARK_LEVEL;

    i = 10;
    while(--i);                    // delay time required by the DAC and comparator

    do
    {
    PIR2bits.C1IF = 0;        // clear comparator interrupt flag C1IF

    i = 1;
    while(--i);                    //delay time for at least one generator period

    }while( PIR2bits.C1IF);      //waiting for absent MARKER

    Proximity_output = 1;       // Proximity output = ON

    // set reference for no MARKER
    DAC1CON1 = NO_MARK_LEVEL;
```

```
        i = 10;
        while(--i);                  // delay time required by the DAC and comparator

        PIR2bits.C1IF = 0;           // reset of the comparator interrupt C1IF

        while(PIR2bits.C1IF==0);     //waiting for MARKER present

        Proximity_output = 0;        // Proximity output = OFF
    }  // end main loop
}
```

**Consumption meter**

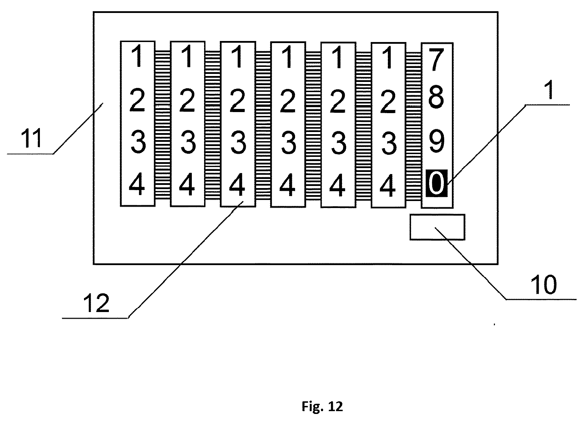

Fig. 12 shows a schematic view of a consumption meter (11) comprising a proximity sensor (10) and a conducive target element (1), fixed to the one of the wheels (12) (last wheel) in the form of a thin metal plate and.

**Claims**

1.  A proximity sensor for detecting a conductive target object (1), comprising:

    an oscillator circuit (2) with an inductance L1, preferably a coil, configured to create an external magnetic field, and a detector circuit (3),
    wherein the external electromagnetic field of the inductance L1 is suitable for and
    configured to create eddy currents in the conductive target object (1),
    and wherein the detector circuit (3) is suitable and configured for examining the amplitude of oscillations of the oscillator circuit (2) and optionally is also suitable for and configured to respectively change the state of an output signal due to changes of the amplitude of oscillations,
    **characterized in that** the oscillator circuit is an electric circuit of a generator of oscillations, comprising the inductance L1, a field transistor T1, preferably an enhancement-mode field transistor, and a resistance R1 connected to the source or the drain of the transistor T1, wherein the inductance L1 is connected directly between the gate and the drain of the transistor T1.

2.  The proximity sensor according to claim 1, **characterized in that** the oscillator circuit additionally comprises a first capacitor C1, optionally exactly one first capacitor C1, connected in parallel to the resistance R1.

3.  The proximity sensor according to claim 1 or 2, **characterized in that** the oscillator circuit additionally comprises a second capacitor $C_{L1}$, optionally exactly one second capacitor $C_{L1}$, connected in parallel to the inductance L1.

4.  The proximity sensor according to claim 1 or 2 or 3, **characterized in that** the oscillator circuit comprises exactly one transistor T1 and/or exactly one inductance L1 and/or exactly one resistance R1.

5.  The proximity sensor according to any of the claims from 1 to 4, **characterized in that** the detector circuit (3) comprises a comparator (4) suitable for and configured to detect a desired level of the amplitude of oscillations of the oscillator circuit (2), wherein a desired level of the amplitude of the oscillations is fed into the one input of comparator (4), while the signal from the inductance L1 is fed to the other input of comparator (4).

6.  The proximity sensor according to claim 5, **characterized in that** the detector circuit (3) comprises a first 1-bit register (6), optionally suitable for and configured to be initially reset and set by means of a signal from the comparator (4) if the signal corresponding to the amplitude of oscillations greater than desired level of the amplitude occurs in any moment in a period of time longer than the period of oscillations.

7.  The proximity sensor according to claim 6, **characterized in that** the detector circuit further comprises a second 1-bit register (7) connected in such a way that the output of the comparator (4) is suitable for setting the first 1-bit register (6) in one state and a first auxiliary signal is suitable for setting the first register (6) in an opposite state, and wherein a second auxiliary signal is suitable for copying the state of the first register (6) to the second register (7).

8. The proximity sensor according to claim 7, **characterized in that** an output signal (target is present) of the sensor is a state of the second register (7), which is set as an inverted state of the first register (6) before the reset of the first register (6).

9. The proximity sensor according to any of the preceding claims, **characterized in that** the sensor is suitable for detecting the target being an RLC circuit, optionally RLC parallel circuit.

10. The proximity sensor according to claim 9, **characterized in that** the resonant frequency of the RLC circuit is close to the frequency of the generator circuit.

11. A consumption meter comprising a rotating element, rotation of which corresponds to a measured flow, **characterized in that** the consumption meter further comprises:

   a conductive target element (1) fixed to said rotating element of the meter (11), and
   the proximity sensor (10) according to any of the preceding claims, said proximity sensor (10) being suitable for and configured to detect the target element (1),
   wherein optionally the target element (1) is made of nonferrous metal.

12. The meter according to claim 11, **characterized in that** the meter (11) comprises:

   a mechanical drum-type counter with wheels and with a conductive target element (1) fixed to at least one one of the wheels (12) of the counter, optionally to the least significant wheel, and
   the proximity sensor (10) according to any of the preceding claims from 1 to 10,
   said proximity sensor being suitable for and configured to detect the target element (1), wherein optionally the target element (1) is made of nonferrous metal.

13. The meter according to claim 11 or 12, **characterized in that the** conductive target element (1) is in the form of a thin metal plate, a coil or a RLC circuit.

Fig. 1

Fig. 2

Fig. 3

**Fig .4**

Fig. 5

**Fig .6**

**Fig . 7**

Fig. 8

**Fig. 9**

Fig. 10

Fig. 11

Fig. 12

Europäisches
Patentamt

European
Patent Office

Office européen
des brevets

# EUROPEAN SEARCH REPORT

Application Number

EP 16 16 8773

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 4 164 706 A (AKITA SIGEYUKI [JP] ET AL) 14 August 1979 (1979-08-14) * figure 5 * | 1-13 | INV. H03B5/12 H03K17/95 |
| A | US 3 636 470 A (OLIVEL ALFREDO ET AL) 18 January 1972 (1972-01-18) * figure 1 * | 1-13 | |
| A | DE 41 02 542 A1 (TURCK WERNER KG [DE]) 30 July 1992 (1992-07-30) * figure 12 * | 1-13 | |
| A | DE 40 21 164 C1 (PEPPERL & FUCHS GMBH & CO KG) 14 November 1991 (1991-11-14) * figure sole * | 1-13 | |
| A | DE 36 43 970 A1 (SIEMENS AG [DE]) 30 June 1988 (1988-06-30) * figure 1 * | 1-13 | |
| A | DE 24 50 889 A1 (SIEMENS AG) 29 April 1976 (1976-04-29) * page 6, paragraph 3 - page 7, paragraph 1; figure 2 * | 1-13 | TECHNICAL FIELDS SEARCHED (IPC)  H03B H03K |
| A | FR 2 001 680 A1 (ITT) 26 September 1969 (1969-09-26) * figure 1 * | 1-13 | |

The present search report has been drawn up for all claims

| Place of search | Date of completion of the search | Examiner |
|---|---|---|
| Munich | 3 November 2016 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 16 8773

This annex lists the patent family members relating to the patent documents cited in the above-mentioned European search report.
The members are as contained in the European Patent Office EDP file on
The European Patent Office is in no way liable for these particulars which are merely given for the purpose of information.

03-11-2016

| Patent document cited in search report | | Publication date | Patent family member(s) | | Publication date |
|---|---|---|---|---|---|
| US 4164706 | A | 14-08-1979 | NONE | | |
| US 3636470 | A | 18-01-1972 | NONE | | |
| DE 4102542 | A1 | 30-07-1992 | NONE | | |
| DE 4021164 | C1 | 14-11-1991 | NONE | | |
| DE 3643970 | A1 | 30-06-1988 | AT 397640 B<br>CH 674343 A5<br>DE 3643970 A1 | | 25-05-1994<br>31-05-1990<br>30-06-1988 |
| DE 2450889 | A1 | 29-04-1976 | NONE | | |
| FR 2001680 | A1 | 26-09-1969 | CH 498520 A<br>DE 1616250 B1<br>ES 363456 A1<br>FR 2001680 A1<br>GB 1251417 A<br>NL 6902018 A<br>SE 334397 B | | 31-10-1970<br>08-09-1971<br>16-12-1970<br>26-09-1969<br>27-10-1971<br>12-08-1969<br>26-04-1971 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 15461535 A